(19) **Europäisches Patentamt European Patent Office Office européen des brevets**

(11) **EP 4 391 378 B1**

(12) **FASCICULE DE BREVET EUROPEEN**

(45) Date de publication et mention de la délivrance du brevet:
**03.09.2025 Bulletin 2025/36**

(21) Numéro de dépôt: **23218543.9**

(22) Date de dépôt: **20.12.2023**

(51) Classification Internationale des Brevets (IPC):
***H03K 3/57*** *(2006.01)*

(52) Classification Coopérative des Brevets (CPC):
**H03K 3/57**

(54) **SOURCE IMPULSIONNELLE DE COURANT ET/OU DE TENSION À TEMPS DE RÉPONSE RAPIDE ET GIGUE SUBNANOSECONDE**

STROM- UND/ODER SPANNUNGSQUELLE MIT SCHNELLER ANSPRECHZEIT UND SUBNANOSEKUNDEN-JITTER

PULSED CURRENT AND/OR VOLTAGE SOURCE WITH FAST RESPONSE TIME AND SUBNANOSECOND JITTER

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **22.12.2022 FR 2214304**

(43) Date de publication de la demande:
**26.06.2024 Bulletin 2024/26**

(73) Titulaire: **Commissariat à l'Energie Atomique et aux Energies Alternatives 75015 Paris (FR)**

(72) Inventeurs:
- **NIKOLOVSKI, Jean-Pierre 13108 Saint-Paul-lez-Durance, Cedex (FR)**
- **ABOULKASSIMI, Driss 13108 Saint-Paul-lez-Durance, Cedex (FR)**

(74) Mandataire: **Atout PI Laplace Immeuble Up On 25 Boulevard Romain Rolland CS 40072 75685 Paris Cedex 14 (FR)**

(56) Documents cités:
FR-A5- 2 093 320     KR-B1- 101 626 372
US-A- 5 883 471

## Description

### Champ d'application

L'invention concerne la production d'une source impulsionnelle synchrone de tension ou de courant de puissance élevée et de durée de l'ordre des nanosecondes. Plus particulièrement, l'invention concerne la génération d'impulsions de courants pour réaliser des tests de compatibilité électromagnétique à travers des charges inductives ou des impulsions de tensions forte surtension pour l'alimentation de charges capacitives telles les charges piézoélectriques et des charges résistives.

### Problème soulevé

Pour tester des dispositifs et/ou composants électroniques soumis à des décharges électrostatiques et devant être exposés à une haute tension, des sources de tension et/ou de courant en continu sont généralement utilisés pour générer des stimuli de test. Cependant, l'application de tensions ou de courants continus de forte amplitude présente des risques d'électrisation pour l'intervenant réalisant le test mais aussi un risque d'endommager le dispositif ciblé.

Ainsi, il existe un besoin pour réaliser une source de courant à forte intensité ou de haute tension permettant de limiter dans le temps et dans l'espace l'exposition de l'intervenant aux risques d'électrisation. L'utilisation de générateurs impulsionnels permet de résoudre partiellement les problématiques de sécurité précitées. Cependant, ce type de sources impulsionnelles présente des pentes de transitions montante et descendante dans le domaine des hautes tensions et courants plafonnés actuellement et respectivement à 250V/ns et 4A/ns.

Plus particulièrement, les tests de compatibilité et de résistance aux impulsions électromagnétiques (test CEM) nécessitent la production d'impulsions électromagnétiques large bande de très courte durée (de l'ordre de quelques nanosecondes) et de forte puissance. Plusieurs domaines d'application sont concernés par ce type de tests tels que l'électronique embarquée, la téléphonie mobile, l'automobile, l'avionique, ou encore les mémoires magnétiques, en particulier leur résistance aux impulsions magnétiques.

Dans le contexte de l'invention, on entend par gigue la durée séparant le front montant d'un signal impulsionnel d'entrée basse tension de la source du front montant de l'impulsion de sortie de haute tension ou de haut courant appliquée au composant à tester.

Dans le contexte de l'invention on entend par « paramètre électrique » un paramètre choisi parmi une tension, un courant ou une variation d'un courant au cours du temps (la pente di/dt).

Les générateurs d'impulsion à haute tension connus sont caractérisés par une gigue entre le signal de déclenchement et l'impulsion produite non maitrisée lorsque l'on souhaite dépasser les amplitudes de tension et de courant obtenues par les solutions de l'état de l'art. Dans ce cas, la gigue peut atteindre plusieurs nanosecondes. L'aspect aléatoire de la gigue engendre des incertitudes dans les résultats des tests réalisés notamment sur les composants les plus rapides.

De plus, les générateurs impulsionnels connus utilisés pour les tests CEM présentent des courants maximum d'impulsion de l'ordre de 30A en court-circuit et des tensions ayant un maximum de 1500V en circuit ouvert.

L'objectif est ainsi de réaliser une source impulsionnelle de tension, de courant ou de variation temporelle de courant présentant une gigue minimisée inférieure à la nanoseconde pour améliorer la caractérisation des circuits. De plus un objectif supplémentaire est de limiter les risques de sécurité pour les intervenants en limitant le recours à des hautes amplitudes desdits paramètres électriques dans l'espace et dans le temps. D'une manière générale, la solution selon l'invention cherche à produire des impulsions électriques de stimulation pour test qui tendent vers un pic de Dirac.

Le document FR 2 093 320 A5 décrit un générateur d'impulsions destiné à engendrer des impulsions de forme désirée, notamment pour la commande de magnétrons, comprenant un réseau formateur d'impulsions, un dispositif pour charger ce réseau, lequel comprend un circuit primaire relié à une source d'alimentation et un circuit secondaire relié au réseau et un interrupteur commandé qui court-circuite périodiquement le montage en série du réseau et de la charge.

### Réponse au problème et apport de solution

Pour pallier les limitations des solutions existantes en ce qui concerne les risques d'électrocution, la non maitrise de la gigue et le contrôle des caractéristiques des impulsions, l'invention propose un dispositif électronique pour générer une impulsion de test pouvant atteindre des amplitudes supérieures en courant et en tensions par rapport aux solutions connues, des pentes de variation temporelles maitrisés et une gigue inférieure à une nanoseconde. Le dispositif selon l'invention se base sur une première phase de transformation et de stockage d'énergie à partir d'un générateur de tension basse tension et forte puissance; et une seconde phase de décharge brusque et rapide d'au moins une partie de l'énergie électrique stockée dans le composant électronique cible de manière à obtenir un pic du paramètre électronique. Le pic est bref et intense de manière à être assimilable à un pic de Dirac. Dans le contexte de l'invention, l'étape de décharge peut être contrôlée par des moyens de contrôle ou spontanée à partir d'un certain seuil de tension. Ainsi, l'invention permet d'augmenter la puissance disponible en disposant simultanément d'une source impulsionnelle de tension élevée (allant jusqu'à plusieurs milliers de volts, par exemple 2000V) et d'un courant de sortie élevé (allant jusqu'à plusieurs dizaines d'ampères, par exemple 50A). L'invention permet en outre d'améliorer la fiabilité des tests car elle réduit la gigue par rapport aux solutions connues.

De plus, l'invention est compatible avec plusieurs domaines d'application tels que :

- Le test de la réponse impulsionnelle d'un transducteur piézoélectrique dont la capacité intrinsèque constitue l'impédance de charge principale dans le domaine de l'acoustique et des MEMS. Dans ce cas le paramètre électronique choisi est la tension électrique.

- La production de flux magnétiques impulsionnels monopolaires ou bipolaires ou avec résonance amortie dans des éléments inductifs pour réaliser des tests de compatibilité électromagnétiques CEM ou de résistances aux impulsions électromagnétiques.

- L'échantillonnage haute fréquence de champs magnétiques ou de courants par génération de forces de Lorentz impulsionnelles.

- L'excitation de transducteurs large bande et l'étude des réponses impulsionnelles électromagnétiques dans les cavités électromagnétiques.

- Les tests de charges résistives pour des usages thermoacoustiques de génération d'ondes acoustiques large bande par production de dilatations thermiques impulsionnelles.

**Résumé /Revendications**

L'invention a pour objet un dispositif électrique pour générer une impulsion de test d'un paramètre électrique choisi parmi un courant, une tension électrique ou la dérivée temporelle d'un courant ; ledit dispositif électrique comprenant :

- au moins un générateur de tension configuré pour générer une impulsion de tension d'entrée pendant une première phase ;
- pour chaque générateur, un transformateur à bobine pour amplifier l'impulsion de tension d'entrée ; le transformateur à bobine ayant un enroulement primaire monté en parallèle avec le générateur associée et un enroulement secondaire ayant une première extrémité et une seconde extrémité;
- une diode de redressement ayant une anode connectée à la seconde extrémité de l'enroulement secondaire et ayant une cathode ;
- un circuit cible comprenant au moins une impédance complexe cible et un élément capacitif ; le circuit cible ayant une première électrode connectée à la cathode de la diode de redressement et une seconde électrode ;
- un circuit de déclenchement configuré pour déclencher une seconde phase en déchargeant ledit élément capacitif à travers le circuit cible de manière à appliquer l'impulsion de test à l'impédance complexe cible;
- une capacité de stockage montée entre la cathode de la diode de redressement et la masse électrique pour stocker au moins une partie de l'énergie électrique fournie par l'enroulement secondaire; ladite capacité de stockage étant distincte de l'élément capacitif du circuit cible.

Selon un aspect particulier de l'invention, le circuit cible comprend en outre un élément résistif, un élément inductif montés en série avec l'élément capacitif ; l'impédance complexe cible étant choisie parmi l'un desdits éléments.

Selon un aspect particulier de l'invention, le circuit de déclenchement comprend :

- un transistor de déclenchement connectant la seconde électrode à la masse électrique ;
- des moyens de contrôle configurés pour générer un signal de déclenchement permettant de maintenir le transistor de déclenchement à l'état bloquant durant la première phase ; et de mettre le transistor de déclenchement à l'état passant durant la seconde phase de manière à activer la décharge de la capacité de stockage dans l'impédance complexe.

Selon un aspect particulier de l'invention, lequel le circuit de déclenchement comprend :

- un transistor de déclenchement connectant la première électrode à la masse électrique ; la seconde électrode étant connectée à la masse électrique ;
- des moyens de contrôle configurés pour générer un signal de déclenchement permettant de maintenir le transistor de déclenchement à l'état bloquant durant la première phase ; et de mettre le transistor de déclenchement à l'état passant durant la seconde phase de manière à activer la décharge de l'élément capacitif dans l'impédance complexe cible.

Selon un aspect particulier de l'invention, le circuit de déclenchement comprend en outre un composant interrupteur à claquage comprenant :

- un premier fil conducteur connecté à la première électrode de l'impédance de charge complexe ;
- un second fil conducteur connecté à la seconde électrode de l'impédance de charge complexe ;

le premier et second fils conducteurs étant séparés d'une première distance inférieure ou égale à 1mm par un volume en diélectrique ; le composant interrupteur à claquage est passant uniquement lorsque la tension entre le premier fil conducteur et le second fil conducteur dépasse un premier seuil prédéterminé ; le premier seuil prédéterminé dépendant de la première distance.

Selon un aspect particulier de l'invention, le composant interrupteur à claquage comprend en outre une micro-vis de réglage solidaire avec second fil conducteur pour contrôler la première distance.

Selon un aspect particulier de l'invention, le circuit de déclenchement comprend en outre :

- une couche métallique placée à une seconde distance du volume en diélectrique, la seconde distance étant inférieure ou égale à 1mm.
- une diode électroluminescente connectée entre le générateur et la masse électrique et placée de manière à émettre un rayon lumineux sur la couche métallique lorsque l'impulsion de tension d'entrée est générée.

Selon un aspect particulier de l'invention, le circuit de déclenchement comprend en outre un tube à gaz de décharge monté en parallèle avec le circuit cible ; le tube à gaz de décharge est passant uniquement lorsque la tension à ces bornes est supérieure à un second seuil prédéterminé.

Selon un aspect particulier de l'invention, le dispositif électrique comprend en outre une diode de court circuit montée en parallèle avec la série formée par l'élément résistif et l'élément inductif.

Selon un aspect particulier de l'invention, le dispositif électrique comprend en outre une diode zener montée dans le sens inverse à partir de la cathode de la diode de redressement ; la diode zener étant connectée en série avec l'élément résistif et l'élément inductif ; la série formée par l'élément résistif et l'élément inductif et la diode zener étant montée en parallèle avec la diode de court circuit.

Selon un aspect particulier de l'invention, l'impédance complexe cible est l'élément capacitif correspondant à un transducteur piézoélectrique. Le paramètre électrique est la tension électrique aux bornes de l'élément capacitif. L'amplitude d'impulsion de test est supérieure à 250V ; la variation de la tension pendant un front montant et/ou descendant de l'impulsion est comprise entre 1V/ns et 500V/ns.

Selon un aspect particulier de l'invention, l'impédance complexe cible est l'élément inductif correspondant à un générateur de Force de Lorentz. L'inductance de l'élément inductif cible est inférieure à 5nH. Le paramètre électrique est le courant électrique à travers l'élément inductif. L'amplitude d'impulsion de test est comprise entre 1A et 100A.

Selon un aspect particulier de l'invention, l'impédance complexe cible est l'élément inductif correspondant à un générateur de flux magnétique. l'inductance de l'élément inductif est comprise entre 5nH et $1\mu H$, pouvant aller jusqu'à $10\mu H$. Le paramètre électrique est la dérivée temporelle du courant à travers l'élément inductif. L'amplitude d'impulsion de test est comprise entre 1A/ns et 400A/ns.

## Description Détaillée

D'autres caractéristiques et avantages de la présente invention apparaîtront mieux à la lecture de la description qui suit en relation aux dessins annexés suivants.

[Fig. 1a] la figure 1a illustre le schéma électrique du dispositif électrique selon un premier mode de réalisation de l'invention.

[Fig. 1b] la figure 1b illustre un organigramme des tensions dans des noeuds du dispositif électrique selon le premier mode de réalisation de l'invention.

[Fig. 1c] la figure 1c illustre le schéma électrique du dispositif électrique selon un deuxième mode de réalisation de l'invention.

[Fig. 1d] la figure 1d illustre le schéma électrique du dispositif électrique selon un troisième mode de réalisation de l'invention.

[Fig. 1e] la figure 1e illustre le schéma électrique du dispositif électrique selon un quatrième mode de réalisation de l'invention.

[Fig. 2a] la figure 2a illustre le schéma électrique du dispositif électrique selon un cinquième mode de réalisation de l'invention.

[Fig. 2b] la figure 2b illustre le schéma électrique du dispositif électrique selon un sixième mode de réalisation de l'invention.

[Fig. 3a] la figure 3a illustre le schéma électrique du dispositif électrique selon un septième mode de réalisation de l'invention.

[Fig. 3b] la figure 3b illustre la tension de sortie du dispositif électrique selon le septième mode de réalisation de l'invention en présence ou en l'absence d'un dispositif de claquage.

[Fig. 4] la figure 4 illustre le schéma électrique du dispositif électrique selon un huitième mode de réalisation de l'invention.

[Fig. 5] la figure 5 illustre le schéma électrique du dispositif électrique selon un neuvième mode de réalisation de l'invention.

[Fig. 6] la figure 6 illustre le schéma électrique du dispositif électrique selon un dixième mode de réalisation de l'invention.

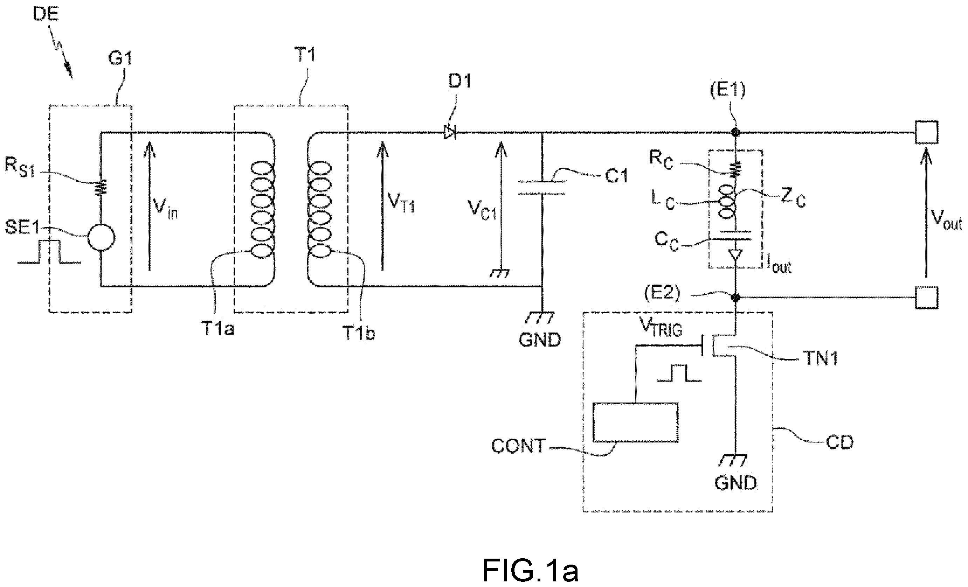

La figure 1a illustre le schéma électrique du dispositif électrique DE selon un premier mode de réalisation de l'invention. Le dispositif électrique DE est configuré pour générer une impulsion de test d'un paramètre électrique choisi parmi un courant $I_{out}$, une tension électrique $V_{out}$ ou la dérivée temporelle d'un courant $dI_{out}/dt$ selon le domaine d'application et la nature du test à effectuer. Le dispositif électrique DE comprend un générateur de tension G1 configuré pour générer une impulsion de tension d'entrée $V_{in}$; un transformateur à bobine T1 ; une diode de redressement D1 ; un circuit cible comprenant au moins une impédance complexe cible Zc à tester ; et un circuit de déclenchement CD.

Le générateur de tension G1 fournit une impulsion de tension d'entrée $V_{in}$ ayant une amplitude comprise entre 25V et 400V, préférentiellement comprise entre 60V et 100V. La durée de l'impulsion de tension d'entrée $V_{in}$ est comprise entre 25ns et 1000ns, de préférence inférieure à 500ns. Le temps de montée 20%-80% de l'impulsion de tension d'entrée $V_{in}$ est inférieur à 10 ns.

Le générateur de tension G1 présente une impédance de sortie inférieure à $2\Omega$. Ainsi, le générateur de tension G1 est capable de fournir un courant de court-circuit d'au moins 50A. Le générateur de tension G1 est configuré pour générer une impulsion de tension d'entrée $V_{in}$ pendant une première phase $\phi 1$, dénommée phase de charge et de transfert d'énergie. Le déroulement de la première phase $\phi 1$ sera détaillé dans une section ultérieure.

Le transformateur à bobine T1 est configuré pour amplifier l'impulsion de tension d'entrée $V_{in}$. Le transformateur à bobine T1 comprend un enroulement primaire T1a monté en parallèle avec le générateur G1 et un enroulement secondaire T1b. L'enroulement secondaire T1b comprend une première extrémité connectée à la masse électrique GND et une seconde extrémité. L'impulsion amplifiée $V_{T1}$ à la sortie du transformateur est la tension entre la première extrémité et la seconde extrémité de l'enroulement secondaire T1b. Le transformateur présente un facteur de transformation compris entre 10 et 18, voire jusqu'à 30. Ainsi, l'amplitude de l'impulsion amplifiée $V_{T1}$ est comprise entre 250V et 2000V, voire jusqu'à 2500V. compte tenu des pertes dans le transformateur T1.

À titre d'exemple, le transformateur T1 est à faible nombre de spires comprenant 5 spires pour l'enroulement primaire T1a et 50 spires pour l'enroulement secondaire T1b. Les spires sont enroulées autour d'une tige ou un tore en un alliage de ferrite de fer doux large bande type Ni-Zn ou Mn-Zn. La tige en ferrite présente un diamètre compris entre 0.75mm et 1cm. Ce dimensionnement permet d'améliorer la compacité spatiale du dispositif électrique DE. L'avantage du choix de matériaux ferrites est la conservation d'une perméabilité magnétique relative $\mu r$ constante jusqu'à des fréquences de 50MHz. De plus, un transformateur T1 ayant un faible nombre de spires limite l'impédance d'entrée associée à l'enroulement primaire et absorbe ainsi un courant impulsionnel et une puissance importants. Cela permet d'exploiter la faible impédance de sortie du générateur d'impulsions basse tension G1.

La diode de redressement D1 présente une cathode et une anode connectée à la seconde extrémité de l'enroulement secondaire T1b. La diode de redressement D1 est montée alors dans le sens passant à partir de la seconde extrémité de l'enroulement secondaire T1b. La diode de redressement D1 permet de convertir l'impulsion amplifiée $V_{T1}$ en une tension continue ayant une amplitude amplifiée par rapport à l'impulsion de tension d'entrée $V_{in}$. La diode de redressement D1 présente un temps de recouvrement inverse $T_{rr}$ inférieur ou égal à 75ns. Pour un rapport de transformation donné, l'augmentation du nombre de spires du transformateur T1 permet d'augmenter le temps de réponse $\tau$ dudit transformateur T1. Le temps de réponse $\tau$ est supérieur au temps de recouvrement inverse $T_{rr}$ de la diode de redressement D1.

Le circuit cible comprend au moins une impédance complexe cible Zc à tester et un élément capacitif $C_c$. À titre d'exemple non limitatif, le circuit cible est un circuit RLC série formé d'un élément résistif $R_c$, un élément inductif $L_c$ et l'élément capacitif $C_c$. Le circuit cible présente une première électrode E1 et une seconde électrode E2. La première électrode E1 est connectée à la cathode de la diode de redressement D1. Dans l'exemple illustré, l'impédance complexe cible Zc est l'élément inductif $L_c$.

Le dispositif électrique DE comprend en outre une capacité de stockage C1 montée entre la cathode de la diode de redressement D1 et la masse électrique GND pour stocker au moins une partie de l'énergie électrique fournie par l'enroulement secondaire T1b.

Le circuit de déclenchement CD est configuré pour déclencher une seconde phase $\phi 2$, dénommée phase de décharge. Ladite seconde phase $\phi 2$ consiste à décharger l'élément capacitif $C_c$ ou la capacité de stockage C1 à travers le circuit cible RLC et plus particulièrement à travers l'impédance inductive $L_c$ à tester de manière à appliquer l'impulsion de test à l'impédance complexe cible $Z_c$. Le circuit de déclenchement CD comprend un transistor TN1 monté en série entre la seconde électrode E2 et la masse électrique GND et un circuit de contrôle CONT pour commander la grille du transistor TN1.

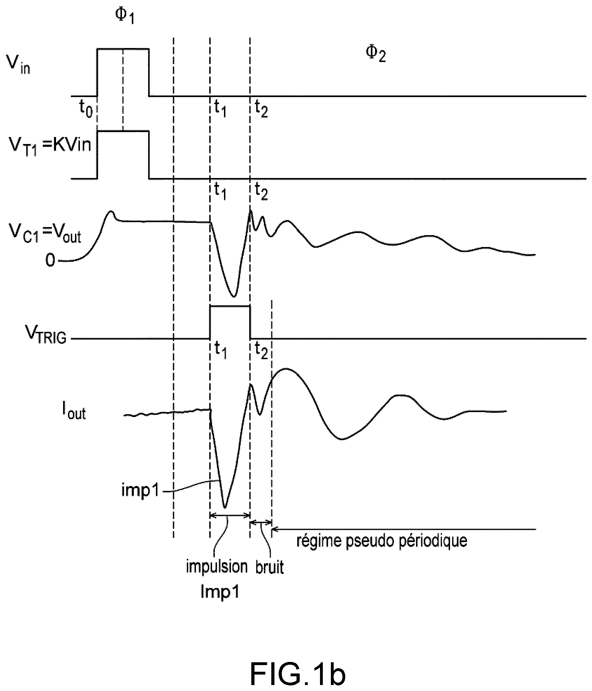

La figure 1b illustre un organigramme des tensions dans des noeuds du dispositif électrique DE selon le premier mode de réalisation de l'invention. L'organigramme n'est pas à l'échelle pour simplifier l'illustration du fonctionnement du dispositif électrique DE.

Pendant la première phase $\phi 1$, le générateur de tension G1 génère une impulsion de tension d'entrée $V_{in}$ ayant une amplitude comprise entre 25V et 120V. Le transformateur à bobine T1 génère une impulsion amplifiée $V_{T1}$ avec un facteur d'amplification inférieur ou égal à 10. Pendant, la première phase $\phi 1$, le circuit de

contrôle CONT est configuré pour maintenir le transistor de déclenchement TN1 à l'état bloquant via le signal de déclenchement $V_{TRIG}$ appliqué sur la grille dudit transistor TN1. Cela permet de couper le chemin électrique entre le nœud E2 et la masse électrique. Il en résulte un transfert et stockage de l'énergie électrique à partir du transformateur T1 par la charge de la capacité de stockage C1. Le potentiel au nœud E1 monte progressivement à une pente supérieure à 6V/ns. À la fin de la première phase φ1 le potentiel au nœud E1 s'établit à une tension constante à une amplitude comprise entre 250V et 1200V. La limitation à une valeur de 1200V sert à ne pas dépasser la tension drain -source maximale du transistor TN1. L'augmentation de la valeur de la capacité de stockage C1 permet de moduler la pente sur la tension au nœud E1 lors de la première phase φ1. Plus la capacité C1 est grande, plus la pente est lente pendant la charge.

La seconde phase φ2 est déclenchée à t1 par la génération d'une impulsion via le signal de déclenchement $V_{TRIG}$ sur la grille du transistor TN1. L'impulsion signal de déclenchement $V_{TRIG}$ est comprise entre 3V et 20V. Le transistor TN1 passe à un état passant et la connexion entre le circuit $R_cL_cC_c$ et la masse est établie. Cela induit une décharge brusque et rapide de la capacité de stockage C1 dans le circuit cible et plus particulièrement dans l'impédance cible Zc (l'inductance Lc dans ce cas). On produit ainsi une impulsion de tension $V_{out}$ et/ou de courant $I_{out}$ dans l'impédance cible Zc entre t1 et t2. Ensuite, un bruit apparaît suivi d'un régime de décharge pseudopériodique amorti. Le courant maximum $I_{out}$ et l'amortissement de la décharge sont contrôlés par la résistance $R_c$. La pente du front descendant de l'impulsion produite Imp1 dépend de la conductivité du transistor TN1 à l'état passant mais aussi du dimensionnement des composants du circuit cible. La largeur de l'impulsion Imp1 correspond à une demi-période propre de la décharge dans le circuit cible $R_cL_cC_c$. Ainsi, la durée de l'impulsion de test est déterminée par le choix de valeur de l'inductance Lc et de la capacité Cc. Le temps de réponse du transistor TN1 doit être inférieur au quart de la période propre du circuit cible $R_cL_cC_c$.

Avantageusement, il est possible de supprimer les oscillations du régime pseudopériodique amorti en réalisant un facteur d'amortissement du circuit $R_cL_cC_c$ supérieur ou égal à 0.7.

Avantageusement, il est possible de ralentir la pente de la décharge de l'élément capacitif $C_c$ en rajoutant une résistance montée en parallèle dudit élément capacitif $C_c$ et typiquement comprise entre 100kΩ et 10MΩ et préférentiellement autour de 1MΩ. Ladite résistance peut alternativement être montée en parallèle de la capacité de stockage C1.

On obtient à titre d'exemple, une impulsion de courant Imp1 rapide avec une variation temporelle de 6A/ns et une intensité maximale de 40A avec le dimensionnement suivant : $V_{C1}$=600V, $C_c$= 1.1nF ; $L_c$=100nH, $R_c$=6Ω.

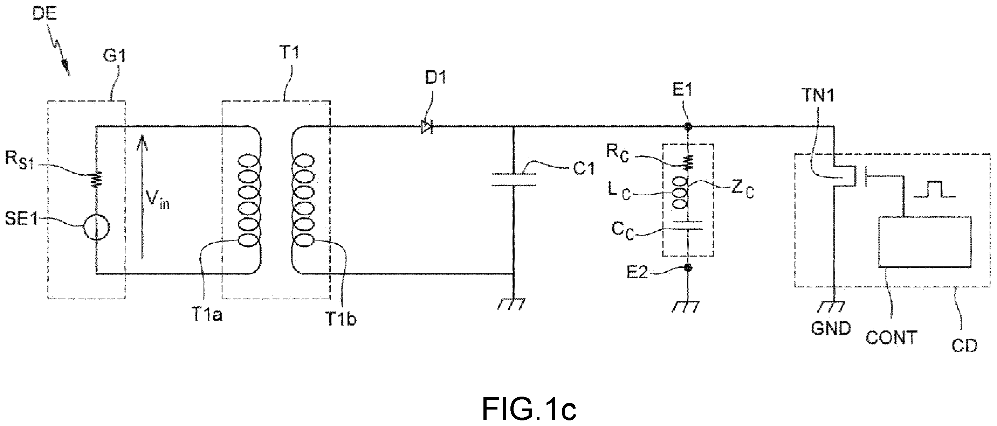

La figure 1c illustre le schéma électrique du dispositif électrique DE selon un deuxième mode de réalisation de l'invention. Le second mode de réalisation diffère du premier mode de réalisation par le montage du circuit de déclenchement CD. En effet, le transistor TN1 est monté entre la première électrode E1 et la masse électrique GND. Le circuit cible $R_cL_cC_c$ est monté entre la cathode de la diode de redressement D1 et la masse électrique GND. Le changement de connexion induit un changement dans le fonctionnement du dispositif électrique DE. L'utilisation de la capacité de stockage est optionnelle dans le second mode de réalisation. Pendant la première phase φ1, l'élément capacitif $C_c$ est chargé par l'impulsion amplifiée provenant du transformateur T1. Lors de la seconde phase φ2, le circuit de contrôle CONT est configuré pour appliquer une impulsion via le signal de déclenchement $V_{TRIG}$ sur la grille du transistor TN1. Le transistor TN1 passe à un état passant et le circuit cible $R_cL_cC_c$ est court-circuité. Cela induit une décharge brusque et rapide de l'élément capacitif $C_c$ dans le circuit cible lui-même et plus particulièrement dans l'impédance cible Zc (l'inductance Lc dans ce cas). On produit ainsi une impulsion de tension $V_{out}$ ou de forte décharge en courant $I_{out}$ dans l'impédance cible Zc à partir de l'instant t1 et avec une durée maximale déterminée par l'intervalle de temps entre t1 et t2 ayant des caractéristiques similaires à ce qui a été décrit précédemment.

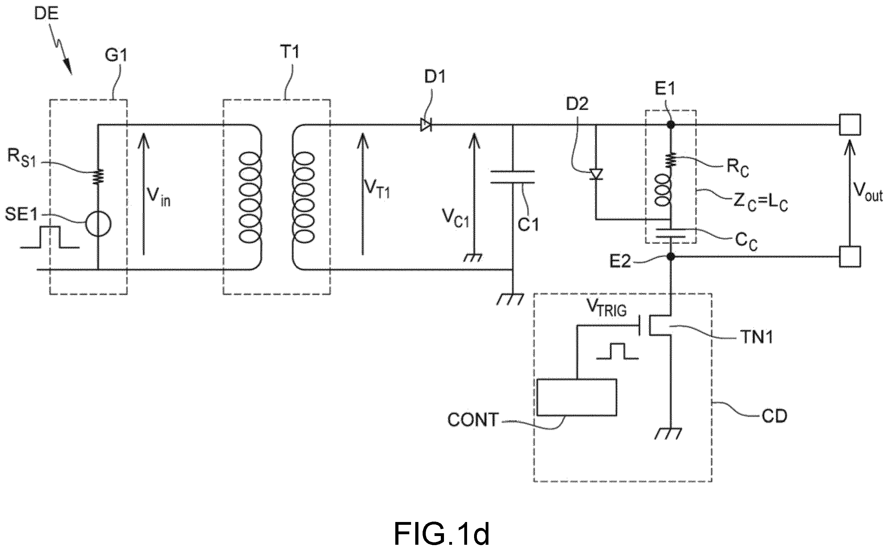

La figure 1d illustre le schéma électrique du dispositif électrique selon un troisième mode de réalisation de l'invention. Le troisième mode de réalisation diffère du premier mode de réalisation par le rajout d'une diode de court-circuit D2. La diode de court-circuit D2 est montée en parallèle à l'ensemble formé par l'élément résistif $R_c$ et l'élément inductif $L_c$. La diode de court-circuit D2 est dans le sens direct par rapport au courant généré par l'enroulement secondaire T1b vers l'élément capacitif $C_c$. L'augmentation de la résistance de l'élément résistif $R_c$ permet d'augmenter la tension aux bornes dudit élément résistif $R_c$ pendant la première phase φ1 à une valeur supérieure à la tension de seuil de la diode de court circuit D2. Il est alors possible d'acheminer le courant fourni par l'enroulement secondaire à travers la diode de court-circuit D2 au lieu de l'élément inductif $L_c$ lors de la charge pendant la première phase φ1. Cela permet d'éviter le rayonnement de l'élément inductif $L_c$ lors de la phase φ1 de charge ce qui représente une source de bruit.

De plus, pendant la seconde phase φ2, la diode de court circuit D2 permet d'éliminer les oscillations pendant le régime pseudopériodique amorti. On obtient ainsi uniquement l'impulsion Imp1 de courant ou de tension.

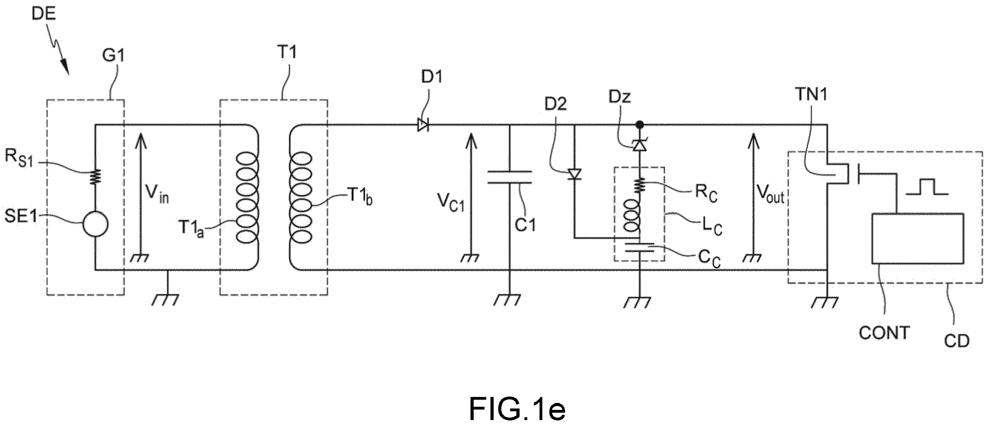

La figure 1e illustre le schéma électrique du dispositif électrique DE selon un quatrième mode de réalisation de l'invention.

Le dispositif électrique DE comprend en outre une diode zener Dz montée dans le sens inverse à partir de la cathode de la diode de redressement D1. La diode zener Dz est connectée entre la cathode de la diode de redressement D1 et la première électrode E1 du circuit cible $R_cL_cC_c$. La branche série formée par l'élément résistif Rc et l'élément inductif Lc et la diode zener Dz est montée en parallèle avec la diode de court circuit D2.

Alternativement, la diode zener est montée en série entre l'élément inductif $L_c$ et l'élément résistif $R_c$. La branche série formée par l'élément résistif Rc et l'élément inductif Lc et la diode zener Dz est montée en parallèle avec la diode de court circuit D2.

Avantageusement, la diode zener Dz est une diode de suppression de transitoire monodirectionnelle. La diode zener Dz a une tension de blocage (clamping en anglais) supérieure à la tension de coude de la diode de court circuit D2. De plus, la diode zener Dz a une capacité en tension inverse faible (autour de 10 pF) par rapport à la celle de l'élément capacitif $C_c$ (généralement supérieure à 100 pF).

L'intégration de la diode zener permet d'éviter un passage de courant dans l'élément inductif $L_c$ durant la première phase $\phi1$ ce qui empêche la production d'une bruit par rayonnement de l'élément inductif $L_c$.

D'une manière générale, l'utilisation de la diode de court-circuit D2, telle que détaillée précédemment, est compatible avec tous les modes de réalisation de l'invention. De plus, l'utilisation de la diode zener Dz, telle que détaillée précédemment, est compatible avec tous les modes de réalisation de l'invention.

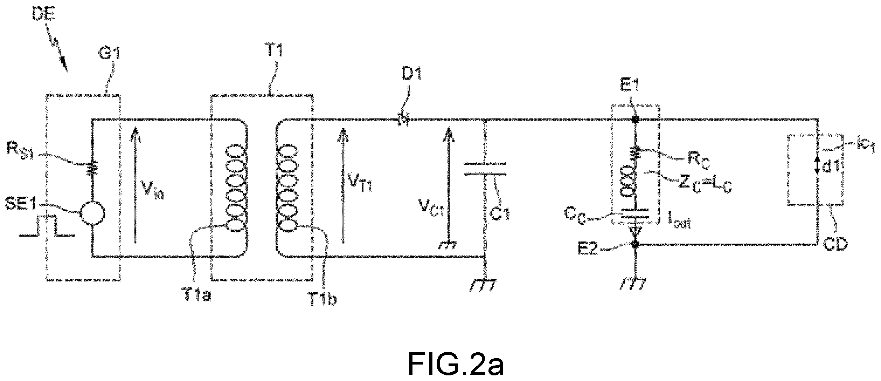

La figure 2a illustre le schéma électrique du dispositif électrique DE selon un cinquième mode de réalisation de l'invention. Le cinquième mode de réalisation diffère du second mode de réalisation par l'implémentation du circuit de déclenchement CD. Le circuit de déclenchement CD est un composant interrupteur à claquage ic1 comprenant : d'une part un premier fil conducteur connecté à la première électrode E1 de l'impédance de charge complexe Zc ; et d'autre part un second fil conducteur connecté à la seconde électrode E2 de l'impédance de charge complexe Zc et à la masse électrique GND. Les premier et second fils conducteurs sont séparés d'une distance d1 inférieure ou égale à 1mm. De préférence, au moins un des fils conducteurs est associé à une électrode solidaire d'un support déformable. Avantageusement, et de manière optionnelle, l'ensemble est capoté hermétiquement pour obtenir une étanchéité à l'humidité. L'espace de séparation est occupé par un volume en un matériau ou un gaz diélectrique. Le composant interrupteur à claquage ic1 est passant uniquement lorsque la tension entre le premier fil conducteur et le second fil conducteur dépasse un premier seuil prédéterminé, dit tension de claquage. La tension de claquage dépend de la première distance d1. La tension de claquage est comprise entre 100V et 1000V et préférentiellement 10% à 30% de moins que la tension de sortie maximale d'un transformateur T1. Ainsi, pendant la première phase $\phi1$, la tension au nœud E1 augmente progressivement suite à l'application de l'impulsion de tension d'entrée $V_{in}$ comme décrit précédemment. L'élément capacitif $C_c$ se charge progressivement pendant cette phase. Lorsque la tension au nœud E1 dépasse la tension de claquage, le composant interrupteur à claquage ic1 devient passant d'une manière brusque. Le circuit cible $R_cL_cC_c$ est ainsi court-circuité, et l'élément capacitif $C_c$ se décharge dans l'élément inductif cible $L_c$. Le claquage engendre ainsi le déclenchement de la seconde phase $\phi2$ d'une manière spontanée et sans aggraver la gigue par rapport aux modes de réalisation utilisant un transistor TN1.

La variation temporelle du courant à travers l'élément inductif $L_c$ au moment du déclenchement de la seconde phase $\phi2$ s'exprime par l'équation suivante:

$$\frac{dIout}{dt}(t1) = \frac{-V0}{Lc}$$ avec V0 le potentiel électrique au nœud E1 du circuit cible $R_cL_cC_c$ à l'instant du claquage. Il est ainsi possible de contrôler la pente de l'impulsion de test Imp1 en modifiant les deux paramètres suivant : l'impédance de l'élément inductif $L_c$ et la tension de claquage V0 du composant interrupteur à claquage ic1.

Le déclenchement par claquage permet de monter à des impulsions de courant et de tension ayant des amplitudes et des pentes de variations supérieures aux amplitudes et pentes des modes de réalisation utilisant un transistor TN1. Le composant interrupteur à claquage ic1 est une solution plus robuste qui absorbe le plus de puissance face à de fortes tensions et intensités de courant. Avec un seul transformateur, il est ainsi possible de générer des impulsions de test en tension dépassant 1000V d'amplitude avec une variation dépassant 10V/ns en temps de montée et 500V/ns en temps de descente. De plus, il est possible de générer des impulsions de test en courant dépassant 50A d'amplitude crête et/ou une variation de 50 A/ns.

Avantageusement, le composant interrupteur à claquage ic1 présente une tension de claquage modulable. Le composant interrupteur à claquage ic1 comprend en outre une micro-vis de réglage solidaire avec second fil conducteur connecté la masse électrique GND pour contrôler la distance d1. Le contrôle de la distance d1 permet de modifier la tension de claquage V0. La modification de la tension de claquage V0 permet de contrôler la pente de l'impulsion Imp1 obtenue suite au déclenchement de la décharge par claquage. La micro-vis de réglage comprend un filetage avec un pas métrique inférieur ou égal de 0.35 mm. Un centième de tour de vis correspond ainsi à un avancement de 3.5 $\mu$m en direction du premier fil conducteur. Cela engendre selon la loi de Paschen, une diminution de 10 V de la tension de claquage V0 par centième de tour de la micro-vis de réglage. Cette variation peut être encore plus faible par insertion d'un élément ressort qui, pour une translation donnée de la vis de réglage, engendre une force opposée imposée par la raideur du ressort. Selon une variante, la micro-vis de réglage agit sur la paroi du support déformable solidaire du second fil conducteur, par exemple un support en Kapton ou un circuit imprimé mince en matériau FR4 sur lequel est soudé un picot constituant l'électrode du second fil conducteur. La distance de séparation d1 peut varier de 0 à 1 mm avec un pas de réglage inférieur ou égal à $1\mu$m. Cela permet de réaliser un contrôle plus précis de la tension de claquage V0 avec un pas de variation inférieur ou égal à 1V. Cela permet alors de moduler d'une manière précise la pente de l'impulsion de test en courant Imp1.

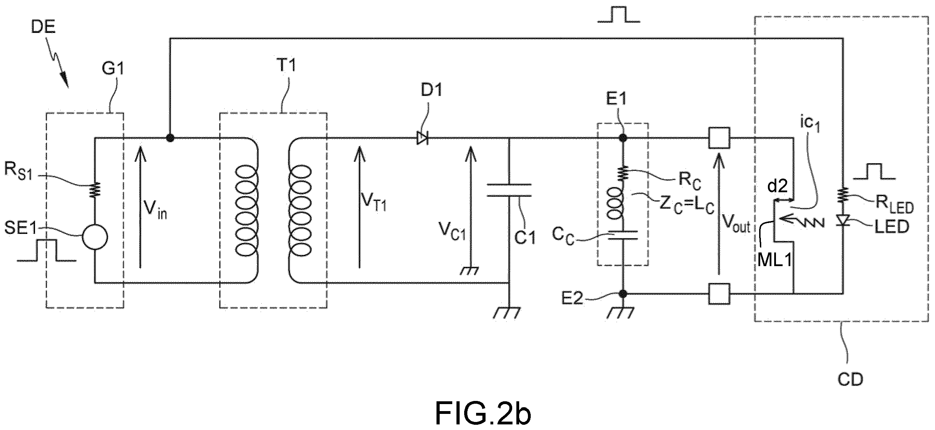

La figure 2b illustre le schéma électrique du dispositif électrique DE selon un sixième mode de réalisation de l'invention. Le sixième mode de réalisation reprend l'ensemble des caractéristiques du cinquième mode de réalisation. Le circuit de déclenchement CD comprend en outre une couche métallique ML1 placée à une seconde distance d2 du volume en diélectrique du composant interrupteur à claquage ic1 ; et une diode électroluminescente LED apte à émettre des rayons ultraviolets. La seconde distance d2 est inférieure ou égale à 1mm. À titre d'exemple, la couche métallique ML1 est une feuille de zinc. La diode électroluminescente LED est connectée entre la sortie du générateur G1 et la masse électrique GND. Une résistance $R_{LED}$ est montée en série entre la diode électroluminescente LED et la sortie du générateur G1 afin de de limiter le courant traversant ladite diode électroluminescente à une intensité inférieure ou égale à 500mA.

La diode électroluminescente LED est placée de manière à émettre un rayon ultraviolet sur la couche métallique ML1. L'émission du rayon ultraviolet est activée alors par l'impulsion de tension d'entrée $V_{in}$. On obtient ainsi une impulsion lumineuse synchronisée avec l'impulsion de tension d'entrée $V_{in}$. Ainsi, la diode électroluminescente LED éclaire de façon impulsionnelle synchrone la surface de la couche métallique ML1. Cela induit un arrachement d'électrons par effet photo-électrique de la couche métallique ML1. L'éclairage impulsionnel UV favorise ainsi le claquage du volume diélectrique, en pratique un gaz, dans lequel baigne le premier fil électrique du composant interrupteur à claquage ic1 portée à une tension croissante très rapidement lors de la première phase $\phi$1. Cela permet de réduire la gigue entre l'impulsion de tension d'entrée $V_{in}$ et le déclenchement de l'impulsion de test Imp1 par claquage à des valeurs inférieures ou égales à 1ns.

Alternativement selon une variante non représentée, la diode électroluminescente LED est commandée par un signal de contrôle externe appliqué entre l'instant de l'impulsion de tension d'entrée $V_{in}$ et l'instant pour lequel la tension de sortie du transformateur T1 se situe 10% au-dessous de la tension de claquage spontanée du circuit de déclenchement CD. Avantageusement, le signal de contrôle externe est synchronisé avec l'impulsion de tension d'entrée $V_{in}$.

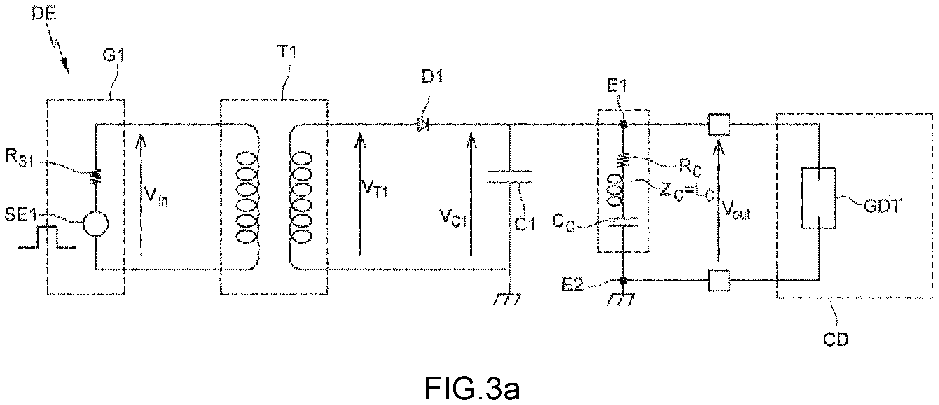

La figure 3a illustre le schéma électrique du dispositif électrique DE selon un septième mode de réalisation de l'invention. Le septième mode de réalisation diffère du cinquième mode de réalisation par l'implémentation du circuit de déclenchement CD. Le circuit de déclenchement CD comprend un tube à gaz de décharge GDT monté en parallèle avec circuit cible $R_cL_cC_c$. Le tube à gaz de décharge GDT est passant uniquement lorsque la tension à ces bornes est supérieure à un second seuil prédéterminé, dit tension de claquage du tube à gaz de décharge. La tension de claquage rapide du tube à gaz de décharge est comprise entre 100V et 10kV. Les constructeurs donnent deux tensions de claquage du tube à gaz, l'une pour une vitesse de variation lente de 100V/$\mu$s, l'autre qui concerne cette invention, pour une vitesse de variation rapide de 1V/ns. Plus la vitesse de variation est rapide en sortie du transformateur T1, plus la tension de claquage augmente. Ainsi, il est avantageux de mieux maitriser est important de maitriser la pente de la tension en sortie du transformateur T1 afin de maitriser le seuil de claquage du tube à gaz. Le dispositif électrique DE fonctionne de la même manière que le cinquième mode de réalisation. Le tube à gaz de décharge GDT comprend un volume de gaz diélectrique encapsulé. L'encapsulation hermétique permet d'éviter les fluctuations de la tension de claquage en isolant le gaz diélectrique de l'humidité et les électrodes du tube à gaz de décharge GDT de l'oxydation. On obtient ainsi, un meilleur contrôle et une meilleure stabilité de la tension de claquage et donc de la pente de l'impulsion de test ainsi qu'un meilleur contrôle de la gigue. En effet, le temps de commutation du claquage par effet d'avalanche est de l'ordre de la nanoseconde. Le temps de commutation est stable et reproductible ce qui veut dire que la gigue est entièrement déterminée par la stabilité de la tension de claquage. Cela permet de minimiser la gigue de déclenchement de l'impulsion de test à des valeurs inférieures ou égales à 1ns. De plus, la durée de vie du tube à gaz GDT peut atteindre plusieurs centaines de milliers de claquages pour des tensions inférieures ou égales à 3000V et des durées de pulses réduites à quelques nanosecondes, ce qui est suffisant pour une campagne de test selon l'invention.

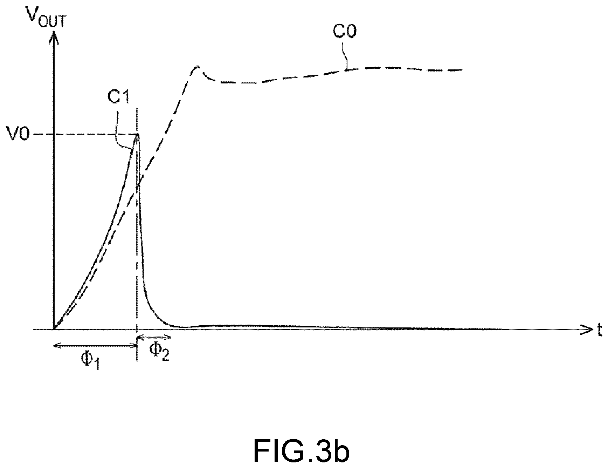

La figure 3b illustre la tension de sortie (courbe C1) du dispositif électrique DE selon le septième mode de réalisation de l'invention comparé à la tension de sortie (courbe C0) d'un transformateur en l'absence d'un tube à gaz de décharge GDT. La courbe C0 présente un plateau de haute tension de l'ordre de 1300V. Cette amplitude correspond à une valeur de 30%(+/-5%) au-dessus de la tension de claquage du tube à gaz de décharge GDT. L'utilisation du claquage permet de générer un pic à une tension de l'ordre de 1000V limitée dans le temps et une faible gigue en limitant l'exposition aux risques pour l'intervenant.

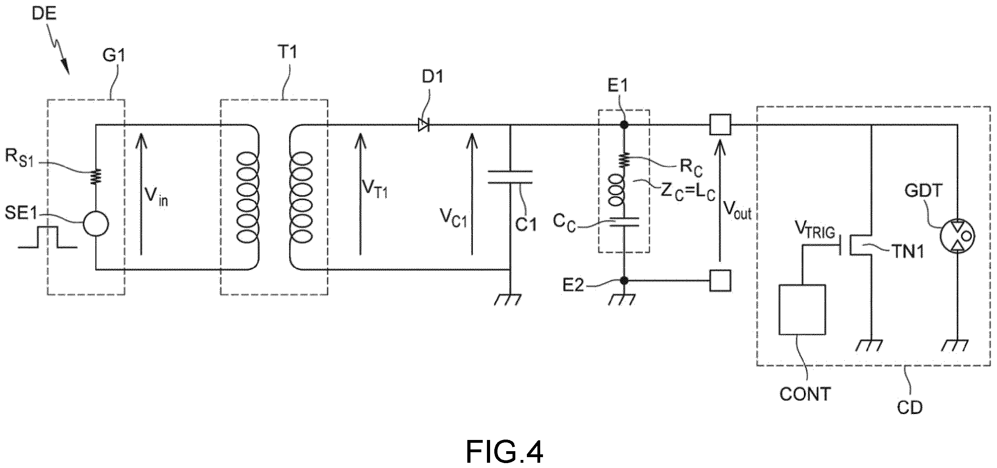

La figure 4 illustre le schéma électrique du dispositif électrique DE selon un huitième mode de réalisation de l'invention. Le circuit de déclenchement CD combine le tube à gaz GDT avec le transistor TN1 commandé par le circuit de contrôle CONT. Cela permet d'offrir une flexibilité entre un déclenchement par claquage spontané du tube à gaz GDT ou un déclenchement commandé via l'activation du transistor TN1.

Alternativement, le circuit de déclenchement CD comprend une pluralité de tubes à gaz $GDT_1$ à $GDT_n$ montés en parallèle. Les tubes à gaz $GDT_1$ à $GDT_n$ présentent des tensions de claquage $V0_1$ à $V0_n$ selon un ordre croissant tel que $V0_1 < V0_2 < ... < V0_{n-1} < V0_n$ ; n étant un entier naturel supérieur à 1. Ainsi, le premier tube à gaz GDT, commence pour un certain nombre d'impulsions à claquer tout seul car il présente la tension de claquage $V0_1$ la plus basse. Au bout d'un certain nombre de claquages, le premier tube à gaz $GDT_1$ vieillit ce qui engendre une augmentation progressive de tension de claquage $V0_1$ jusqu'à rejoindre la tension de claquage suivante $V0_2$. les deux tubes $GDT_1$ et $GDT_2$ commutent en même temps et en parallèle, ce qui divise par deux le courant dans chaque tube. Ensuite, leur tension de claquage augmente avec l'érosion par le même mécanisme pour atteindre la tension de claquage du tube à gaz suivant et ainsi de suite. Cela permet de multiplier la durée de vie du dispositif électrique DE par le nombre de tubes à gaz montés en parallèle par rapport à un circuit de déclenchement comprenant un seul tube à gaz.

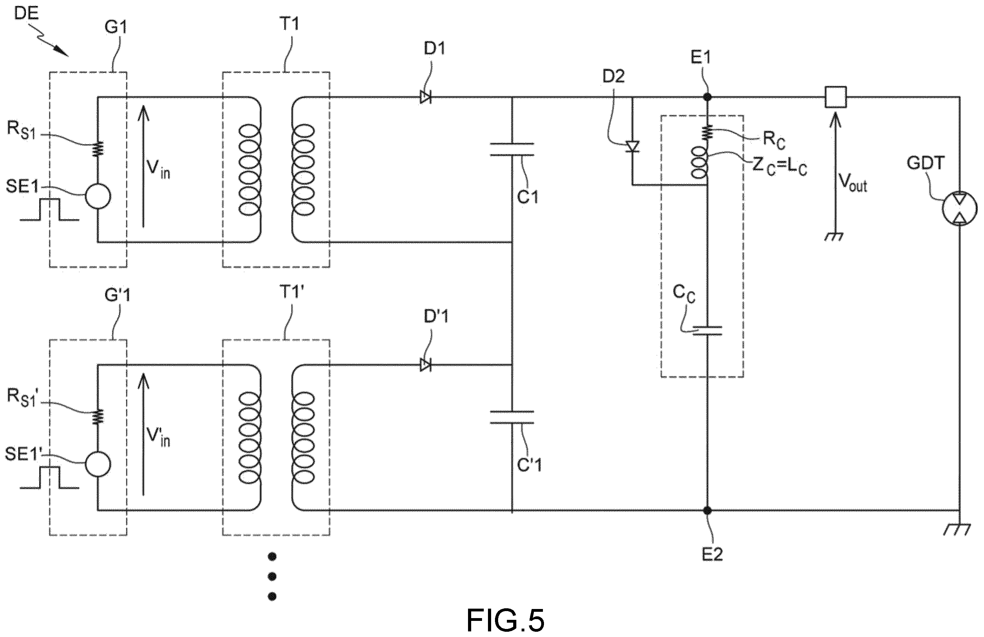

La figure 5 illustre le schéma électrique du dispositif électrique DE selon un neuvième mode de réalisation de l'invention. Le dispositif électrique DE comprend en outre un second générateur de tension G1' configuré pour générer une seconde impulsion de tension d'entrée $V'_{in}$ pendant une première phase $\phi 1$ simultanément avec le premier générateur de tension G1. D'une manière similaire au premier générateur G1, la seconde impulsion de tension d'entrée $V'_{in}$ est amplifiée par un second transformateur T1' de la même manière décrite précédemment pour la première impulsion de tension d'entrée $V_{in}$. De même, le second signal d'entrée est redressé via une seconde diode de redressement D1' sur une seconde capacité de stockage C'1. La seconde capacité de stockage C'1 est montée en série avec la première capacité de stockage C1. La branche en série formée par les deux capacités de stockage C1 et C'1 est montée en parallèle avec le circuit cible $R_cL_cC_c$. Cela permet de doubler la pente de tension et de courant au moment du claquage et d'atteindre des tensions et des courants de claquage plus élevés.

Plus généralement, il est possible de dupliquer l'ensemble formé par le générateur G1, le transformateur T1, la diode de redressement D1 et la capacité de stockage C1, N fois. Par exemple, pour N=4 avec des transformateurs ayant un rapport de transformation de N2/N1 de 10, on obtient :

- une amplitude maximale de la tension de claquage V0 de 4kV ;

- une pente de la tension en sortie de transformateur supérieure à 25V/ns ;

- et une pente maximale du courant de décharge dans une inductance de 100 nH allant jusqu'à 40A/ns.

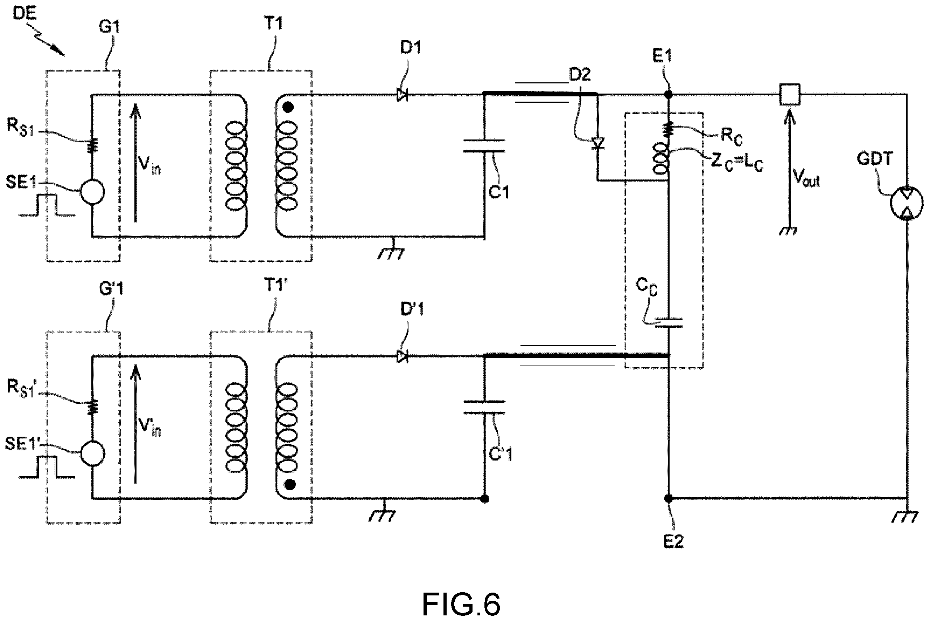

La figure 6 illustre le schéma électrique du dispositif électrique DE selon un dixième mode de réalisation de l'invention. Selon ce mode de réalisation, le dispositif électrique DE comprend une pluralité de transformateurs d'impulsions formant deux ensembles : un premier ensemble formé par des transformateurs non-inverseurs et un second ensemble formé par des transformateurs inverseurs. Nous allons décrire ce mode de réalisation avec un exemple non-limitatif où le dispositif électrique DE comprend deux transformateurs inversés l'un par rapport à l'autre.

Dans l'exemple illustré, le dispositif électrique DE comprend en outre un second générateur de tension G1' configuré pour générer une seconde impulsion de tension d'entrée $V'_{in}$ pendant une première phase $\phi 1$ simultanément avec le premier générateur de tension G1. D'une manière similaire au premier générateur G1, la seconde impulsion de tension d'entrée $V'_{in}$ est amplifiée par un second transformateur T1' de la même manière décrite précédemment pour la première impulsion de tension d'entrée $V_{in}$. De même, le second signal d'entrée est redressé via une seconde diode de redressement D1' sur une seconde capacité de stockage C'1. La seconde capacité de stockage C'1 est montée entre la cathode de la diode de redressement D'1 et la masse électrique GND pour stocker au moins une partie de l'énergie électrique fournie par l'enroulement secondaire du second transformateur. Les transformateurs du second ensemble présentent un enroulement secondaire (ou le primaire, mais pas les deux en même temps) enroulé dans le sens contraire de l'enroulement secondaire des transformateurs de l'autre ensemble. Cela engendre une tension inverse en sortie d'un transformateur du premier ensemble.

Le premier transformateur T1 est monté en non-inverseur et produit ainsi une tension positive par rapport à la masse. Le potentiel électrique du nœud commun entre la première capacité de stockage C1 et la diode de redressement D1 est positif. Le second transformateur T1' est monté en inverseur et produit ainsi une tension négative par rapport à la masse. Ainsi, le potentiel électrique au nœud commun entre la seconde capacité de stockage C'1 et la diode de redressement D'1 est négatif. Le montage alterné est obtenu de la manière suivante : l'enroulement secondaire (ou primaire) du second transformateur T1' est dans le sens inverse du transformateur T1. Ainsi, le circuit cible voit une tension positive $+V_p$ sur sa première électrode E1 et une tension négative $-V_p$ sur sa seconde électrode E2. On obtient ainsi une tension différentielle de $2V_p$ aux bornes du circuit cible sans soumettre les câbles et connecteurs de raccordement au circuit cible à des hautes tensions électriques. Cela permet d'éviter le claquage des câbles de connexion et des autres composants tout en permettant d'appliquer une tension suffisante aux bornes du circuit cible mais aussi du tube à gaz de décharge GDT. On rappelle que l'activation du tube à gaz de décharge GDT nécessite l'application de hautes tensions électriques à ses bornes. L'application de fortes amplitudes de tension peut endommager les connecteurs et les câbles utilisés et plus particulièrement des câbles coaxiaux. L'utilisation d'une tension différentielle via deux ensembles de transformateurs inversés l'un par rapport aux autres, comme décrit pour ce mode de réalisation, permet de résoudre ce problème. Cela présente l'avantage de permettre de diminuer la taille des câbles utilisés en terme de diamètre (et donc moins rigides diélectriquement et mécaniquement) et ainsi réduire significativement l'encombrement et le poids du dispositif électrique DE selon l'invention.

Dans la section suivante, nous allons donner des exemples applicatifs du dispositif électrique selon l'invention.

Le dispositif électrique DE est par exemple utilisé pour une compagne de test d'un dispositif acoustique comprenant un transducteur piézoélectrique. L'impédance complexe cible Zc est l'élément capacitif $C_c$ correspondant au transducteur piézoélectrique. Par exemple, la capacité de l'élément $C_c$ est comprise entre 10pF et 50nF. L'impulsion de test paramètre électrique est une impulsion de tension électrique appliquée aux bornes de l'élément capacitif $C_c$. L'amplitude d'impulsion de test est supérieure à 500V. La variation de la tension pendant un front montant et/ou descendant de l'impulsion est comprise entre 1V/ns et 500V/ns.

Le dispositif électrique DE est par exemple utilisé pour une compagne de test d'un dispositif électromagnétique. L'impédance complexe cible Zc est l'élément inductif $L_c$ configuré pour fonctionner comme un générateur de Force de Lorentz. L'inductance de l'élément inductif cible $L_c$ est inférieure à 5nH. Le paramètre électrique de test impulsionnel est le courant électrique $I_{out}$ à travers l'élément inductif $L_c$. L'amplitude d'impulsion de test est comprise entre 1A et 100A.

Alternativement, l'impédance complexe cible Zc est l'élément inductif $L_c$ configuré pour fonctionner comme un générateur de flux magnétique. L'inductance de l'élément inductif $L_c$ est comprise entre 5nH et 1$\mu$H, pouvant aller jusqu'à 10$\mu$H. Le paramètre électrique de test impulsionnel est la dérivée temporelle du courant $dI_{out}/dt$ à travers l'élément inductif $L_c$. L'amplitude d'impulsion de test est comprise entre 1A/ns et 400A/ns.

**Revendications**

1. Dispositif électrique (DE) pour générer une impulsion de test d'un paramètre électrique choisi parmi un courant ($I_{out}$), une tension électrique ($V_{out}$) ou la dérivée temporelle d'un courant ($dI_{out}/dt$) ; ledit dispositif électrique (DE) comprenant :

    - au moins un générateur de tension (G1) configuré pour générer une impulsion de tension d'entrée ($V_{in}$) pendant une première phase ($\phi$1) ;

    - pour chaque générateur (G1), un transformateur à bobine (T1) pour amplifier l'impulsion de tension d'entrée ($V_{in}$) ; le transformateur à bobine (T1) ayant un enroulement primaire (T1a) monté en parallèle avec le générateur (G1) associée et un enroulement secondaire (T1b) ayant une première extrémité et une seconde extrémité ;

    - une diode de redressement (D1) ayant une anode connectée à la seconde extrémité de l'enroulement secondaire (T1b) et ayant une cathode ;

    - un circuit cible ($R_cL_cC_c$) comprenant au moins une impédance complexe cible (Zc) et un élément capacitif ($C_c$); le circuit cible ($R_cL_cC_c$) ayant une première électrode (E1) connectée à la cathode de la diode de redressement (D1) et une seconde électrode (E2) ;

    - un circuit de déclenchement (CD) configuré pour déclencher une seconde phase ($\phi$2) en déchargeant ledit élément capacitif ($C_c$) à travers le circuit cible ($R_cL_cC_c$) de manière à appliquer l'impulsion de test à l'impédance complexe cible (Zc) ;

    - une capacité de stockage (C1) montée entre la cathode de la diode de redressement (D1) et la masse électrique (GND) pour stocker au moins une partie de l'énergie électrique fournie par l'enroulement secondaire (T1b) ; ladite capacité de stockage (C1) étant distincte de l'élément capacitif du circuit cible.

2. Dispositif électrique (DE) selon la revendication 1 dans lequel le circuit cible ($R_cL_cC_c$) comprend en outre un élément résistif ($R_c$), un élément inductif ($L_c$) montés en série avec l'élément capacitif ($C_c$) ; l'impédance complexe cible (Zc) étant choisie parmi l'un desdits éléments.

3. Dispositif électrique (DE) selon l'une quelconque des revendications 1 ou 2 dans lequel le circuit de déclenchement (CD) comprend :

    - un transistor de déclenchement (TN1) connectant la seconde électrode (E2) à la masse électrique (GND) ;
    - des moyens de contrôle (CONT) configurés pour générer un signal de déclenchement ($V_{TRIG}$) permettant de maintenir le transistor de déclenchement (TN1) à l'état bloquant durant la première phase ($\phi$1) ; et de mettre le transistor de déclenchement (TN1) à l'état passant durant la seconde phase ($\phi$2) de manière à activer la décharge de la capacité de stockage (C1) dans l'impédance complexe (Zc).

4. Dispositif électrique (DE) selon l'une quelconque des revendications 1 ou 2 dans lequel le circuit de déclenchement (CD) comprend :

- un transistor de déclenchement (TN1) connectant la première électrode (E1) à la masse électrique (GND) ; la seconde électrode étant connectée à la masse électrique (GND) ;
- des moyens de contrôle (CONT) configurés pour générer un signal de déclenchement ($V_{TRIG}$) permettant de maintenir le transistor de déclenchement (TN1) à l'état bloquant durant la première phase ($\phi$1) ; et de mettre le transistor de déclenchement (TN1) à l'état passant durant la seconde phase ($\phi$2) de manière à activer la décharge de l'élément capacitif (Cc) dans l'impédance complexe cible (Zc).

5. Dispositif électrique (DE) selon l'une quelconque des revendications 1 à 4 dans lequel le circuit de déclenchement (CD) comprend en outre un composant interrupteur à claquage (ic1) comprenant :

- un premier fil conducteur connecté à la première électrode (E1) de l'impédance de charge complexe (Zc) ;
- un second fil conducteur connecté à la seconde électrode (E2) de l'impédance de charge complexe (Zc) ;

le premier et second fils conducteurs étant séparés d'une première distance (d1) inférieure ou égale à 1mm par un volume en diélectrique ; le composant interrupteur à claquage (ic1) est passant uniquement lorsque la tension entre le premier fil conducteur et le second fil conducteur dépasse un premier seuil prédéterminé ; le premier seuil prédéterminé dépendant de la première distance (d1).

6. Dispositif électrique (DE) selon la revendication 5 dans lequel le composant interrupteur à claquage (ic1) comprend en outre une micro-vis de réglage solidaire avec second fil conducteur pour contrôler la première distance (d1).

7. Dispositif électrique (DE) selon l'une quelconque des revendications 5 ou 6 dans lequel le circuit de déclenchement (CD) comprend en outre :

- une couche métallique (ML1) placée à une seconde distance (d2) du volume en diélectrique, la seconde distance étant inférieure ou égale à 1mm ;
- une diode électroluminescente (LED) connectée entre le générateur (G1) et la masse électrique (GND) et placée de manière à émettre un rayon lumineux sur la couche métallique (ML1) lorsque l'impulsion de tension d'entrée ($V_{in}$) est générée.

8. Dispositif électrique (DE) selon l'une quelconque des revendications 1 à 7 dans lequel le circuit de déclenchement (CD) comprend en outre un tube à gaz de décharge (GDT) monté en parallèle avec le circuit cible ($R_cL_cC_c$) ; le tube à gaz de décharge (GDT) est passant uniquement lorsque la tension à ces bornes est supérieure à un second seuil prédéterminé.

9. Dispositif électrique (DE) selon l'une quelconque des revendications 2 à 8 comprenant en outre une diode de court circuit (D2) montée en parallèle avec la série formée par l'élément résistif (Rc) et l'élément inductif (Lc).

10. Dispositif électrique (DE) selon la revendication 9 comprenant en outre une diode zener montée dans le sens inverse à partir de la cathode de la diode de redressement (D1) ; la diode zener étant connectée en série avec l'élément résistif (Rc) et l'élément inductif (Lc) ; la série formée par l'élément résistif (Rc) et l'élément inductif (Lc) et la diode zener (Dz) étant montée en parallèle avec la diode de court circuit (D2).

11. Dispositif électrique (DE) selon l'une quelconque des revendications 2 à 10 dans lequel :

- l'impédance complexe cible (Zc) est l'élément capacitif ($C_c$) correspondant à un transducteur piézoélectrique ;
- Le paramètre électrique est la tension électrique ($V_{out}$) au bornes de l'élément capacitif ($C_c$) ;
- L'amplitude d'impulsion de test est supérieure à 250V ; la variation de la tension pendant un front montant et/ou descendant de l'impulsion est comprise entre 1V/ns et 500V/ns.

12. Dispositif électrique (DE) selon l'une quelconque des revendications 2 à 10 dans lequel :

- l'impédance complexe cible (Zc) est l'élément inductif (Lc) correspondant à un générateur de Force de Lorentz ; l'inductance de l'élément inductif cible ($L_c$) est inférieure à 5nH ;
- le paramètre électrique est le courant électrique ($I_{out}$) à travers l'élément inductif ($L_c$) ;
- l'amplitude d'impulsion de test est comprise entre 1A et 100A.

13. Dispositif électrique (DE) selon l'une quelconque des revendications 2 à 10 dans lequel :

- l'impédance complexe cible (Zc) est l'élément inductif ($L_c$) correspondant à un générateur de flux magnétique ; l'inductance de l'élément inductif ($L_c$) est comprise entre 5nH et 1$\mu$H ;

- le paramètre électrique est la dérivée temporelle du courant ($dI_{out}/dt$) à travers l'élément inductif ($L_c$) ;
- l'amplitude d'impulsion de test est comprise entre 1A/ns et 400A/ns.

**Patentansprüche**

1. Elektrische Vorrichtung (DE) zum Erzeugen eines Testimpulses eines elektrischen Parameters, der aus einem Strom ($I_{out}$), einer elektrischen Spannung ($V_{out}$) oder der zeitlichen Ableitung eines Stroms ($dI_{out}/dt$) ausgewählt ist; wobei die elektrische Vorrichtung (DE) Folgendes umfasst:

    - mindestens einen Spannungsgenerator (G1), der so konfiguriert ist, dass er während einer ersten Phase ($\phi$1) einen Eingangsspannungsimpuls ($V_{in}$) erzeugt;
    - für jeden Generator (G1), einen Spulentransformator (T1) zum Verstärken des Eingangsspannungsimpulses ($V_{in}$); wobei der Spulentransformator (T1) eine Primärwicklung (T1a), die parallel zu dem zugehörigen Generator (G1) montiert ist, und eine Sekundärwicklung (T1b) mit einem ersten Ende und einem zweiten Ende aufweist;
    - eine Gleichrichterdiode (D1), die eine Anode aufweist, die mit dem zweiten Ende der Sekundärwicklung (T1b) verbunden ist, und eine Kathode aufweist;
    - eine Zielschaltung ($R_cL_cC_c$), die mindestens eine komplexe Zielimpedanz (Zc) und ein kapazitives Element ($C_c$) umfasst; wobei die Zielschaltung ($R_cL_cC_c$) eine erste Elektrode (E1), die mit der Kathode der Gleichrichterdiode (D1) verbunden ist, und eine zweite Elektrode (E2) aufweist;
    - eine Auslöseschaltung (CD), die so konfiguriert ist, dass sie eine zweite Phase ($\phi$2) auslöst, indem sie das kapazitive Element ($C_c$) durch die Zielschaltung ($R_cL_cC_c$) entlädt, um den Testimpuls an die komplexe Zielimpedanz (Zc) anzulegen;
    - eine Speicherkapazität (C1), die zwischen der Kathode der Gleichrichterdiode (D1) und der elektrischen Masse (GND) montiert ist, um mindestens einen Teil der von der Sekundärwicklung (T1b) gelieferten elektrischen Energie zu speichern; wobei die Speicherkapazität (C1) von dem kapazitiven Element der Zielschaltung getrennt ist.

2. Elektrische Vorrichtung (DE) gemäß Anspruch 1, wobei die Zielschaltung ($R_cL_cC_c$) ferner ein Widerstandselement (Rc), ein induktives Element ($L_c$) umfasst, die mit dem kapazitiven Element ($C_c$) in Reihe montiert sind; wobei die komplexe Zielimpedanz (Zc) aus einem der Elemente ausgewählt ist.

3. Elektrische Vorrichtung (DE) nach einem der Ansprüche 1 oder 2, wobei die Auslöseschaltung (CD) Folgendes umfasst:

    - einen Auslösetransistor (TN1), der die zweite Elektrode (E2) mit der elektrischen Masse (GND) verbindet;
    - Steuermittel (CONT), die so konfiguriert sind, dass sie ein Auslösesignal ($V_{TRIG}$) erzeugen, mit dem der Auslösetransistor (TN1) während der ersten Phase ($\phi$1) im Sperrzustand gehalten werden kann; und mit dem der Auslösetransistor (TN1) während der zweiten Phase ($\phi$2) in den Durchlasszustand versetzt werden kann, um die Entladung der Speicherkapazität (C1) in die komplexe Impedanz (Zc) zu aktivieren.

4. Elektrische Vorrichtung (DE) nach einem der Ansprüche 1 oder 2, wobei die Auslöseschaltung (CD) Folgendes umfasst:

    - einen Auslösetransistor (TN1), der die erste Elektrode (E1) mit der elektrischen Masse (GND) verbindet; wobei die zweite Elektrode mit der elektrischen Masse (GND) verbunden ist;
    - Steuermittel (CONT), die so konfiguriert sind, dass sie ein Auslösesignal ($V_{TRIG}$) erzeugen, mit dem der Auslösetransistor (TN1) während der ersten Phase ($\phi$1) im Sperrzustand gehalten werden kann; und mit dem der Auslösetransistor (TN1) während der zweiten Phase ($\phi$2) in den Durchlasszustand versetzt werden kann, um die Entladung des kapazitiven Elements (Cc) in die komplexe Zielimpedanz (Zc) zu aktivieren.

5. Elektrische Vorrichtung (DE) nach einem der Ansprüche 1 bis 4, wobei die Auslöseschaltung (CD) ferner eine Durchschlagschaltkomponente (ic1) umfasst, die Folgendes umfasst:

    - einen ersten Leiterdraht, der mit der ersten Elektrode (E1) der komplexen Lastimpedanz (Zc) verbunden ist;
    - einen zweiten Leiterdraht, der mit der zweiten Elektrode (E2) der komplexen Lastimpedanz (Zc) verbunden ist;

wobei der erste und der zweite Leiterdraht durch ein dielektrisches Volumen um einen ersten Abstand (d1) von kleiner oder gleich 1 mm voneinander getrennt sind; das Durchschlagschaltelement (ic1) nur dann durchlassend ist, wenn die Spannung zwischen dem ersten Leiterdraht und dem zweiten Leiterdraht einen ersten vorbestimmten Schwellenwert überschreitet; wobei der erste vorbestimmte Schwellenwert von dem ersten Abstand (d1) abhängt.

6. Elektrische Vorrichtung (DE) nach Anspruch 5, wobei die Durchschlagschaltkomponente (ic1) ferner eine mit dem zweiten Leiterdraht einstückige Mikro-Stellschraube umfasst, um den ersten Abstand (d1) zu steuern.

7. Elektrische Vorrichtung (DE) nach einem der Ansprüche 5 oder 6, wobei die Auslöseschaltung (CD) ferner Folgendes umfasst:

   - eine Metallschicht (ML1), die in einem zweiten Abstand (d2) vom dielektrischen Volumen platziert ist, wobei der zweite Abstand kleiner oder gleich 1 mm ist;
   - eine Leuchtdiode (LED), die zwischen dem Generator (G1) und der elektrischen Masse (GND) angeschlossen und so platziert ist, dass sie einen Lichtstrahl auf die Metallschicht (ML1) aussendet, wenn der Eingangsspannungsimpuls ($V_{in}$) erzeugt wird.

8. Elektrische Vorrichtung (DE) nach einem der Ansprüche 1 bis 7, wobei die Auslöseschaltung (CD) ferner eine Gasentladungsröhre (GDT) umfasst, die parallel zur Zielschaltung ($R_cL_cC_c$) montiert ist; wobei die Gasentladungsröhre (GDT) nur dann durchlassend ist, wenn die Spannung an diesen Anschlüssen größer als ein zweiter vorbestimmter Schwellenwert ist.

9. Elektrische Vorrichtung (DE) nach einem der Ansprüche 2 bis 8, ferner umfassend eine Kurzschlussdiode (D2), die parallel zu der durch das Widerstandselement (Rc) und das induktive Element (Lc) gebildeten Reihe montiert ist.

10. Elektrische Vorrichtung (DE) nach Anspruch 9, ferner umfassend eine Zenerdiode, die in der umgekehrten Richtung von der Kathode der Gleichrichterdiode (D1) ausgehend montiert ist; wobei die Zenerdiode in Reihe mit dem Widerstandselement (Rc) und dem induktiven Element (Lc) geschaltet ist; wobei die durch das Widerstandselement (Rc) und das induktive Element (Lc) und die Zenerdiode (Dz) gebildete Reihe parallel zur Kurzschlussdiode (D2) montiert ist.

11. Elektrische Vorrichtung (DE) nach einem der Ansprüche 2 bis 10, wobei:

    - die komplexe Zielimpedanz (Zc) das kapazitive Element ($C_c$) ist, das einem piezoelektrischen Wandler entspricht;
    - der elektrische Parameter die elektrische Spannung ($V_{out}$) an den Anschlüssen des kapazitiven Elements ($C_c$) ist;
    - die Testimpulsamplitude größer als 250 V ist; die Änderung der Spannung während einer ansteigenden und/oder abfallenden Flanke des Impulses zwischen 1 V/ns und 500 V/ns liegt.

12. Elektrische Vorrichtung (DE) nach einem der Ansprüche 2 bis 10, wobei:

    - die komplexe Zielimpedanz (Zc) das induktive Element (Lc) ist, das einem Lorentzkraftgenerator entspricht; wobei die Induktivität des induktiven Zielelements (Lc) kleiner als 5 nH ist;
    - der elektrische Parameter der elektrische Strom ($I_{out}$) durch das induktive Element ($L_c$) ist;
    - die Testimpulsamplitude zwischen 1 A und 100 A liegt.

13. Elektrische Vorrichtung (DE) nach einem der Ansprüche 2 bis 10, wobei:

    - die komplexe Zielimpedanz (Zc) das induktive Element ($L_c$) ist, das einem Magnetflussgenerator entspricht; wobei die Induktivität des induktiven Elements ($L_c$) zwischen 5 nH und 1 $\mu$H liegt;
    - der elektrische Parameter die zeitliche Ableitung des Stroms ($I_{out}$) durch das induktive Element ($L_c$) ist;
    - die Testimpulsamplitude zwischen 1 A/ns und 400 A/ns liegt.

**Claims**

1. An electrical device (DE) for generating a test pulse of an electrical parameter chosen from among a current ($I_{out}$), a voltage ($V_{out}$) or the time derivative of a current ($dI_{out}/dt$); said electrical device (DE) comprising:

   - at least one voltage generator (G1) configured for generating an input voltage pulse ($V_{in}$) during a first phase ($\phi$1);
   - for each generator (G1), a coil transformer (T1) for amplifying the input voltage pulse ($V_{in}$); the coil transformer (T1) having a primary winding (T1a) connected in parallel with the associated generator (G1) and a secondary winding (T1b) having a first end and a second end;
   - a rectifier diode (D1) having an anode connected to the second end of the secondary winding (T1b) and having a cathode;
   - a target circuit ($R_cL_cC_c$) comprising at least one target complex impedance (Zc) and a capacitive element ($C_c$); the target circuit ($R_cL_cC_c$) having a first electrode (E1) connected to the cathode of the rectifier diode (D1) and a second electrode (E2);

- a trigger circuit (CD) configured for triggering a second phase ($\phi$2) by discharging said capacitive element ($C_c$) through the target circuit ($R_cL_cC_c$) so as to apply the test pulse to the target complex impedance (Zc);

- a storage capacitance (C1) mounted between the cathode of the rectifier diode (D1) and the electrical ground (GND) for storing at least some of the electric energy supplied by the secondary winding (T1b); said storage capacitance (C1) being separate from the capacitive element of the target circuit.

2. The electrical device (DE) according to claim 1, wherein the target circuit ($R_cL_cC_c$) further comprises a resistive element ($R_c$), an inductive element ($L_c$), both mounted in series with the capacitive element ($C_c$); the target complex impedance (Zc) being chosen from among any of said elements.

3. The electrical device (DE) according to any one of claims 1 or 2, wherein the trigger circuit (CD) comprises:

- a trigger transistor (TN1) connecting the second electrode (E2) to the electrical ground (GND);
- control means (CONT) configured to generate a trigger signal ($V_{TRIG}$) for keeping the trigger transistor (TN1) in the blocking state during the first phase ($\phi$1); and for putting the trigger transistor (TN1) in the conducting state during the second phase ($\phi$2), so as to activate the discharge of the storage capacitance (C1) into the complex impedance (Zc).

4. The electrical device (DE) according to any one of claims 1 or 2, wherein the trigger circuit (CD) comprises:

- a trigger transistor (TN1) connecting the first electrode (E1) to the electrical ground (GND); the second electrode being connected to the electrical ground (GND);
- control means (CONT) configured to generate a trigger signal ($V_{TRIG}$) for keeping the trigger transistor (TN1) in the blocking state during the first phase ($\phi$1); and for putting the trigger transistor (TN1) into the conducting state during the second phase ($\phi$2), so as to activate the discharge of the capacitive element (Cc) into the target complex impedance (Zc).

5. The electrical device (DE) according to any one of claims 1 to 4, wherein the trigger circuit (CD) further comprises a breakdown switch component (ic1) comprising:

- a first conducting wire connected to the first electrode (E1) of the complex load impedance (Zc);
- a second conducting wire connected to the second electrode (E2) of the complex load impedance (Zc);

the first and second conducting wires being separated by a first distance (d1) of 1 mm or less by a dielectric volume; the breakdown switch component (ic1) being conducting only when the voltage between the first conducting wire and the second conducting wire exceeds a first predetermined threshold; the first predetermined threshold depending on the first distance (d1).

6. The electrical device (DE) according to claim 5, wherein the breakdown switch component (ic1) further comprises an adjustment micro-screw integral with the second conducting wire for controlling the first distance (d1).

7. The electrical device (DE) according to any one of claims 5 or 6, wherein the trigger circuit (CD) further comprises:

- a metallic layer (ML1) placed at a second distance (d2) from the dielectric volume, the second distance being of 1 mm or less;
- a light-emitting diode (LED) connected between the generator (G1) and the electrical ground (GND) and placed so as to emit a light ray onto the metallic layer (ML1) when the input voltage pulse ($V_{in}$) is generated.

8. The electrical device (DE) according to any one of claims 1 to 7, wherein the trigger circuit (CD) further comprises a gas discharge tube (GDT) connected in parallel with the target circuit ($R_cL_cC_c$); the gas discharge tube (GDT) is conducting only when the voltage at these terminals is above a second predetermined threshold.

9. The electrical device (DE) according to any one of claims 2 to 8, further comprising a short-circuit diode (D2) connected in parallel with the series formed by the resistive element (Rc) and the inductive element (Lc).

10. The electrical device (DE) according to claim 9, further comprising a Zener diode mounted in the reverse direction from the cathode of the rectifier diode (D1); the Zener diode being connected in series with the resistive element (Rc) and the inductive element (Lc); the series formed by the resistive element (Rc) and the inductive element (Lc) and the Zener diode (Dz) being mounted in parallel with the short-circuit diode (D2).

11. The electrical device (DE) according to any one of claims 2 to 10, wherein:

   - the target complex impedance (Zc) is the capacitive element ($C_c$) corresponding to a piezoelectric transducer;
   - the electrical parameter is the voltage ($V_{out}$) at the terminals of the capacitive element ($C_c$);
   - the test pulse amplitude is greater than 250 V; the variation of the voltage during a rising and/or falling edge of the pulse is between 1 V/ns and 500 V/ns.

12. The electrical device (DE) according to any one of claims 2 to 10, wherein:

   - the target complex impedance (Zc) is the inductive element (Lc) corresponding to a Lorentz force generator; the inductance of the target inductive element ($L_c$) is less than 5 nH;
   - the electrical parameter is the electric current ($I_{out}$) through the inductive element ($L_c$);
   - the test pulse amplitude is between 1 A and 100 A.

13. The electrical device (DE) according to any one of claims 2 to 10, wherein:

   - the target complex impedance (Zc) is the inductive element ($L_c$) corresponding to a magnetic flux generator; the inductance of the inductive element ($L_c$) is between 5 nH and 1 $\mu$H;
   - the electrical parameter is the time derivative of the current ($dI_{out}/dt$) through the inductive element ($L_c$);
   - the test pulse amplitude is between 1 A/ns and 400 A/ns.

FIG.1a

$\Phi_1$

$V_{in}$

$t_0$          $t_1$   $t_2$          $\Phi_2$

$V_{T1} = KV_{in}$

$t_1$   $t_2$

$V_{C1} = V_{out}$

0

$V_{TRIG}$

$t_1$   $t_2$

$I_{out}$

imp1

impulsion bruit
Imp1

régime pseudo périodique

# FIG.1b

FIG.1c

EP 4 391 378 B1

FIG.1d

EP 4 391 378 B1

FIG.1e

FIG.2a

EP 4 391 378 B1

FIG.2b

FIG.3a

EP 4 391 378 B1

FIG.3b

FIG.4

FIG.5

FIG.6

EP 4 391 378 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2093320 A5